# EUROPEAN PATENT SPECIFICATION

(11) **EP 4 597 084 B1**
(45) Date of publication and mention of the grant of the patent: **02.12.2026**
(21) Application number: 23904063.7
(22) Date of filing: 15.12.2023
(51) Int. Cl.: G01N 21/94, G01N 1/28, G01N 1/38, G01N 1/40, G01N 21/73, G01N 27/42, G01N 27/48, G01R 31/36, H01M 4/36

(54) **METHOD FOR DETECTING METAL IMPURITIES IN ELECTRODE ACTIVE MATERIAL**
VERFAHREN ZUR DETEKTION VON METALLVERUNREINIGUNGEN IN ELEKTRODENAKTIVMATERIAL
PROCÉDÉ DE DÉTECTION D'IMPURETÉS MÉTALLIQUES DANS UN MATÉRIAU ACTIF D'ÉLECTRODE

(30) Priority: 15.12.2022 KR 20220176331; 14.12.2023 KR 20230182194
(43) Date of publication of application: 06.08.2025
(73) Proprietor: LG Energy Solution, Ltd., Seoul 07335 (KR); Seoul National University R&DB Foundation, Seoul 08826 (KR)
(72) Inventor: CHO, A Ra, Daejeon 34122 (KR); KIM, Sang Woo, Daejeon 34122 (KR); CHUNG, Taek Dong, Seoul 08826 (KR); SHIM, Woo Yeoul, Seoul 08826 (KR); WON, Jung Hye, Daejeon 34122 (KR); YOUN, Yeu Young, Daejeon 34122 (KR)
(74) Representative: Goddar, Heinz J.
(86) International application number: PCT/KR2023/020778
(87) International publication number: WO 2024/128864

(56) References cited:
- JP-A- 2010 107 502
- JP-A- 2011 069 646
- KR-A- 20140 048 370
- KR-A- 20200 132 434
- KR-A- 20210 044 986
- KR-A- 20210 098 625
- KR-B1- 101 466 628

## Description

### TECHNICAL FIELD

The present invention relates to a method for detecting a metal foreign material in an electrode active material, and more particularly, to a method for detecting a fine metal foreign material 40 µm or less, which is hardly removable in advance, and quantitatively analyzing an amount thereof.

### BACKGROUND ART

Among secondary battery materials, metal foreign materials contained in electrode active materials may be precipitated on a surface of a negative electrode during charging and discharging to form an internal short circuit, which may cause capacity reduction, low voltage failure, and/or fire. Accordingly, for the purpose of managing the quality of secondary batteries, an amount of metal foreign materials in electrode active materials needs to be measured and evaluated.

Accordingly, typically, a method of removing metal foreign materials in electrode active materials using a magnetic separator, or a method of measuring an amount of metal foreign materials in electrode active materials through ICP analysis and managing the amount to be within a certain range has been used. However, these conventional methods are incapable of detecting metal foreign materials of small particle size. Specifically, metal foreign materials having a particle size of 40 µm or less are hardly removable in advance using a magnetic separator, and metal foreign materials contained in a low amount of less than 1 ppm are hardly measurable through ICP analysis due to a significant influence of matrix effect caused by electrode active material components.

Accordingly, for the purpose of managing the amount of metal foreign materials in electrode active materials, there is a need to develop a method capable of detecting fine nonmagnetic metal foreign materials and quantitatively analyzing the amount thereof.
JP 2011 069646 A discloses a method for determining the amount/concentration of a metal or metal nanoparticles, the method comprising the steps: - adding an acid to the nanoparticles to dissolve the particles/metals, which acid is preferably nitric acid, - reducing the dissolved metal ions electrochemically to deposit the corresponding metals in a detaching unit, and - the deposited metal atoms are ionized again and the area of the current peak detected by the current amount measurement is determined and converted to the amount of the metal.
JP 2010 107502 A discloses a method wherein the amount of cadmium selenium, cadmium tellurium or silver nanoparticles in a solution is determined. The nanoparticles are dissolved, the metallic component is reduced and subsequently re-dissolved to determine the dissolution stripping charge.

### DISCLOSURE OF THE INVENTION

### TECHNICAL PROBLEM

In order to address the above-described tasks, an aspect of the present invention provides a detection method capable of quantitatively detecting a very small amount of fine metal foreign materials contained in an electrode active material.

### TECHNICAL SOLUTION

According to an aspect of the present invention, provided is a method for detecting a metal foreign material in an electrode active material, wherein the method includes a first step of dissolving an electrode active material in an aqueous nitric acid solution to form a metal foreign material extraction solution, a second step of plating a metal foreign material in the metal foreign material extraction solution on a carbon electrode, wherein the second step is performed by immersing the carbon electrode in the metal foreign material extraction solution and then applying a current to allow a potential difference in which a metal component of the electrode active material is not reduced and the metal foreign material to be extracted is reduced; and a third step of measuring an amount of the metal foreign material plated on the electrode.

In this case, the electrode active material may include a metal foreign material having a particle size of 40 µm or less, wherein the metal foreign material may be Cu.

In addition, the electrode active material may be a positive electrode active material, wherein the positive electrode active material may have a D₅₀ of 1 to 40 µm.

Meanwhile, the first step is preferably performed in the conditions that the metal foreign material has a solubility of 80% or greater and a metal component of the electrode active material has a solubility of 50% or less. Specifically, the first step may be performed by dissolving the electrode active material in an aqueous nitric acid solution having a nitric acid concentration of 20 to 40 wt% and then stirring the resulting product at room temperature for at least 20 hours.

Thereafter, the third step may be performed by dissolving the metal foreign material plated on the electrode using acid and then measuring an amount of the dissolved metal foreign material through inductively coupled plasma (ICP) or anodic stripping voltammetry.

When the method of ICP is used, the acid may include hydrochloric acid, nitric acid, hydrogen peroxide, or a mixture thereof, and may preferably include at least one of hydrochloric acid and nitric acid, and hydrogen peroxide.

Further embodiments are disclosed in the dependent claims.

### ADVANTAGEOUS EFFECTS

A detection method according to the present invention selectively recovers a metal foreign material in an electrode active material using an aqueous nitric acid solution, extracts the metal foreign material from the electrode active material by selectively plating the metal foreign material on an electrode through an electrochemical method, and then measures an amount of the metal foreign material plated on the electrode, and may thus minimize a matrix effect of a metal component in the electrode active material to quantitatively analyze an amount of the metal foreign material having a particle size of 40 µm or less and contained in an amount of less than 1 ppm.

### MODE FOR CARRYING OUT THE INVENTION

Hereinafter, the present invention will be described in detail.

Through repeated research on managing metal foreign materials in electrode active materials, which influence battery performance and safety, the present inventors have devised a method for selectively recovering a metal foreign material in an electrode active material using an aqueous nitric acid solution, plating the metal foreign material on a carbon electrode and then measuring an amount of the metal foreign material plated on the electrode, and thus minimizing a matrix effect of a metal component in the electrode active material to quantitatively detect an amount of the metal foreign material having a particle size of 40 µm or less and contained in an amount of less than 1 ppm, and thus have completed the invention.

Specifically, the method for detecting a metal foreign material in an electrode active material according to the present invention includes a first step of dissolving an electrode active material in an aqueous nitric acid solution to form a metal foreign material extraction solution, a second step of plating a metal foreign material in the metal foreign material extraction solution on a carbon electrode, wherein the second step is performed by immersing the carbon electrode in the metal foreign material extraction solution and then applying a current to allow a potential difference in which a metal component of the electrode active material is not reduced and the metal foreign material to be extracted is reduced; and a third step of measuring an amount of the metal foreign material plated on the electrode.

Hereinafter, the method for detecting a metal foreign material in an electrode active material according to the present invention will be described in detail.

### (1) Step 1: Eluting metal foreign material

First, an electrode active material is dissolved in an aqueous nitric acid solution, and a metal foreign material is eluted to form a metal foreign material extraction solution (first step).

In this case, the electrode active material may include a metal foreign material having a particle size of 40 µm or less, and the metal foreign material may be at least one selected from the group consisting of Cu, Zn, Ti, Sn, Pb, and an alloy thereof, and may preferably be Cu.

The electrode active material may be a positive electrode active material or a negative electrode active material, and may preferably be a positive electrode active material. Meanwhile, the positive electrode active material may have a D₅₀ of 1 to 40 µm, preferably 1 to 25 µm.

The first step is to selectively extract metal foreign materials contained in the positive electrode active material and uses an aqueous nitric acid solution as an extraction solvent. Specifically, the first step may be performed by adding an electrode active material to an aqueous nitric acid solution and stirring the resulting product for a certain period of time to allow metal in the electrode active material to elute.

In order to increase the extraction rate of metal foreign material, the first step is preferably performed in the conditions that the metal foreign material has a solubility of 80% or greater and a metal component that makes up the electrode active material, such as Ni, Co, Mn, and Al (for convenience, referred to as an 'electrode active material metal component'), has a solubility of 50% or less. The solubility of the metal foreign material and the solubility of the metal component of the electrode active material vary depending on the concentration, elution time, and elution temperature of the nitric acid aqueous solution. Therefore, the solubility of the metal foreign material and the solubility of the metal component of the electrode active material may be regulated by appropriately controlling the concentration of the nitric acid aqueous solution used and conditions of the metal ion elution, according to the type of metal foreign material to be detected.

For example, when the metal foreign material to be detected is copper (Cu), preferably, an aqueous nitric acid solution having a nitric acid concentration of 20 to 40 wt% is used. This is because when the nitric acid aqueous solution concentration satisfies the above range, the solubility of copper increases and the solubility of transition metals becomes relatively low, leading to an increase in copper extraction rate.

In addition, when the metal foreign material to be detected is copper (Cu), preferably, an electrode active material is dissolved in an aqueous nitric acid solution, and then stirred at room temperature, for example, at 10 °C to 30 °C for at least 1 hour, preferably for 1 hour to 30 hours to elute the metal foreign material. When the elution temperature and time satisfy the above range, the solubility of copper in the nitric acid aqueous solution increases relative to the metal component of the electrode active material, and thus the copper ratio in the extraction solution may increase.

However, when the type of metal foreign material to be detected varies, the concentration of the nitric acid aqueous solution and conditions of the elution may also vary accordingly.

The metal foreign material in the electrode active material is extracted in the same manner as above, and then the solution containing the metal foreign material is separated through a method such as centrifugation to obtain a metal foreign material extraction solution.

When metal is eluted using the difference between the solubility of the metal component of the electrode active material and the solubility of the metal foreign material as in the present invention, an amount of the metal component of the electrode active material to be eluted can be minimized. Specifically, using the method as described above, the amount of the metal component of the electrode active material contained in the extraction solution may be reduced to a level of one-half to one-third or less compared to the amount contained in the electrode active material.

### (2) Step 2: Plating

Thereafter, the metal foreign material contained in the metal foreign material extraction solution obtained through the first step is plated on a carbon electrode (second step).

The second step is to selectively extract the metal foreign material from the metal foreign material extraction solution, and is performed by immersing the carbon electrode in the metal foreign material extraction solution and applying a current to the electrode. In this case, the current may be applied to have a potential difference such that the metal component of the electrode active material is not reduced, but the metal foreign material to be extracted is reduced. In this case, the potential difference varies according to the type of metal foreign material, and may thus be appropriately regulated according to the type of metal foreign material to be detected.

The metal foreign material extraction solution obtained through the first step contains metal foreign materials and metal components of the electrode active material, such as Ni, Co, and Mn as well. Therefore, in order to accurately measure the amount of the metal foreign material, the metal foreign material to be detected and the metal component of the electrode active material need to be separated.

Therefore, in the present invention, a current is applied to the extraction solution in a voltage range at which the metal foreign material to be detected is reduced, and the metal foreign material is reduced and precipitated on an electrode (positive electrode) to form a plating layer, thereby separating the metal foreign material from the extraction solution. When the metal foreign material is separated through electroplating as such, only the metal foreign material is selectively reduced and precipitated in the plating layer to create an environment that is not affected by a matrix effect caused by the metal component of the electrode active material, and accordingly, even a very small amount of the metal foreign material contained at a level of ppb may be quantitatively measured.

### (3) Step 3: Measuring metal foreign material

Thereafter, an amount of the metal foreign material plated on the electrode is measured (third step). In this case, the measurement of the amount of the metal foreign material may be performed, for example, through electrochemical analysis methods such as inductively coupled plasma (ICP) or anodic stripping voltammetry.

In this case, the measurement of the amount of the metal foreign material using inductively coupled plasma (ICP) may be performed by dissolving the metal foreign material plated on the electrode with acid to prepare a sample solution and then measuring the amount of the metal foreign material in the sample solution using an inductively coupled plasma optical emission spectrometer (ICP-OES), an inductively coupled plasma atomic emission spectrometer (ICP-AES), or an inductively coupled plasma mass spectrometer (ICP-MS).

In this case, the acid may include hydrochloric acid, nitric acid, hydrogen peroxide, or a mixture thereof, and may preferably include at least one of hydrochloric acid and nitric acid, and hydrogen peroxide.

As described above, only the metal foreign material is selectively reduced and precipitated in the plating layer obtained through the second step, and accordingly, the environment that is not affected by a matrix effect caused by the metal component of the electrode active material is created. Therefore, even the metal foreign material contained in an extremely small amount at the level of ppb may be analyzed through the method of ICP.

Meanwhile, the measurement of the amount of the metal foreign material using the anode stripping voltammetry may be performed by applying a potential difference of opposite polarity to the potential difference applied in the second step to the electrode plated with the metal foreign material to ionize the metal foreign material in the plating layer and measuring an amount of current generated during this process to measure an amount of the metal foreign material.

When the amount of the metal foreign material using the electrochemical methods as described above, the amount may be simply measured without a separate treatment process for measuring the amount.

### MODE FOR CARRYING OUT THE INVENTION

Hereinafter, the present invention will be described in more detail with reference to specific embodiments.

### Example 1

50 mL of a 20 wt% aqueous nitric acid solution was added to 10 g of a positive electrode active material (NCM811), stirred at room temperature at 300 rpm for 24 hours, and then centrifuged at 8000 rpm for 10 minutes to prepare a metal foreign material extraction solution A.

8 ml of the metal foreign material extraction solution A was placed in an electrochemical cell, and a three-electrode system provided with a glassy carbon electrode as a working electrode, a silver chloride electrode (Ag/AgCl) as a reference electrode, and a platinum wire (Pt wire) as a counter electrode was prepared.

Then, -0.2 V was applied to the glassy carbon electrode for a total of 120 seconds to plate metal in the metal foreign material extraction solution A. In this case, plating was performed while the solution was stirred at 300 rpm for 60 seconds using a stirrer, and the stirrer was stopped for the remaining 60 seconds to allow the solution to reach equilibrium.

### Example 2

A metal foreign material extraction solution B was prepared and plated in the same process as Example 1, except that 0.11 mg of copper particles were mixed with about 10 g of a positive electrode active material (NCM811).

### Example 3

A metal foreign material extraction solution C was prepared and plated in the same process as Example 1, except that 0.13 mg of copper particles were mixed with about 10 g of a positive electrode active material (NCM811).

### Experimental Example 1

10 g of each of the metal foreign material extraction solutions A to C prepared in Examples 1 to 3 was taken, and then an amount of Cu was measured using ICP-OES equipment. The measurement results are shown in Table 1.

### Experimental Example 2

After plating was completed in Examples 1 to 3, a voltage of 0.3 V was applied to oxidize the metal, and the stripping charge was measured (anodic stripping voltammetry, ASV). The measurement results are shown in table 1 below.

**[Table 1]**

| | Cu amount (µM) measured through ICP-OES | Stripping charge (µC) measured through ASV |
|---|---|---|
| Example 1 | Not measurable | 10.2 |
| Example 2 | 29.2 | 20.7 |
| Example 3 | 35.3 | 23.6 |

Table 1 shows that in the metal foreign material extraction solution of Example 1 in which no additional metal foreign material (Cu) was added, the metal foreign material is contained in a very small amount in the positive electrode active material, and thus the amount of the metal foreign material is not measurable using ICP-OES, but quantification is achievable when the measurement is performed using ASV after plating, as in the method of the present invention. Meanwhile, in Examples 2 and 3, an additional metal foreign material (Cu) was added to increase the amount of the metal foreign material, and thus the amount of the metal foreign material is measurable using ICP-OES, and as shown in Table 1, it is seen that with the increase in the amount of the metal foreign materials measured through ICP-OES, charges value measured through ASV also rise. This indicates that the charge values measured through ASV may represent the amount of the metal foreign material. Therefore, it is seen that according to the method of the present invention, quantifying a very small amount of the metal foreign material that is not measurable through ICP is achievable.

## Claims

1. A method for detecting a metal foreign material in an electrode active material, the method comprising:
a first step of dissolving an electrode active material in an aqueous nitric acid solution to form a metal foreign material extraction solution;
a second step of plating a metal foreign material in the metal foreign material extraction solution on a carbon electrode, wherein the second step is performed by immersing the carbon electrode in the metal foreign material extraction solution and
then applying a current to allow a potential difference in which a metal component of the electrode active material is not reduced and the metal foreign material to be extracted is reduced; and
a third step of measuring an amount of the metal foreign material plated on the electrode.

2. The method of claim 1, wherein the electrode active material comprises a metal foreign material having a particle size of 40 µm or less.

3. The method of claim 2, wherein the metal foreign material is at least one selected from the group consisting of Cu, Zn, Ti, Sn, Pb, and an alloy thereof.

4. The method of claim 1, wherein the first step is performed in the conditions that the metal foreign material has a solubility of 80% or greater and a metal component of the electrode active material has a solubility of 50% or less.

5. The method of claim 1, wherein the aqueous nitric acid solution has a nitric acid concentration of 20 to 40 wt%.

6. The method of claim 1, wherein the first step is performed by dissolving the electrode active material in an aqueous nitric acid solution having a nitric acid concentration of 20 to 40 wt%, and then stirring the resulting product at room temperature for at least 20 hours.

7. The method of claim 1, wherein the third step is performed by dissolving the metal foreign material plated on the electrode using acid and then measuring an amount of the dissolved metal foreign material through inductively coupled plasma (ICP).

8. The method of claim 7, wherein the acid comprises hydrochloric acid, nitric acid, hydrogen peroxide, or a mixture thereof.

9. The method of claim 7, wherein the acid comprises at least one of hydrochloric acid and nitric acid, and hydrogen peroxide.

10. The method of claim 1, wherein the third step is performed through anodic stripping voltammetry.

## Patentansprüche

1. Verfahren zum Detektieren eines Metallfremdmaterials in einem Elektrodenaktivmaterial, wobei das Verfahren umfasst:
einen ersten Schritt des Auflösens eines Elektrodenaktivmaterials in einer wässrigen Salpetersäurelösung, um eine Metallfremdmaterialextraktionslösung zu bilden;
einen zweiten Schritt des Plattierens eines Metallfremdmaterials in der Metallfremdmaterialextraktionslösung auf eine Kohlenstoffelektrode, wobei der zweite Schritt durch Eintauchen der Kohlenstoffelektrode in die Metallfremdmaterialextraktionslösung und dann Anlegen eines Stroms durchgeführt wird, um eine Potentialdifferenz zu ermöglichen, bei der eine Metallkomponente des Elektrodenaktivmaterials nicht reduziert wird und das zu extrahierende Metallfremdmaterial reduziert wird; und
einen dritten Schritt des Messens einer Menge des auf die Elektrode plattierten Metallfremdmaterials.

2. Verfahren nach Anspruch 1, wobei das Elektrodenaktivmaterial ein Metallfremdmaterial mit einer Teilchengröße von 40 µm oder weniger umfasst.

3. Verfahren nach Anspruch 2, wobei das Metallfremdmaterial mindestens eines ausgewählt aus der Gruppe bestehend aus Cu, Zn, Ti, Sn, Pb und einer Legierung davon ist.

4. Verfahren nach Anspruch 1, wobei der erste Schritt unter den Bedingungen durchgeführt wird, dass das Metallfremdmaterial eine Löslichkeit von 80 % oder mehr aufweist und eine Metallkomponente des Elektrodenaktivmaterials eine Löslichkeit von 50 % oder weniger aufweist.

5. Verfahren nach Anspruch 1, wobei die wässrige Salpetersäurelösung eine Salpetersäurekonzentration von 20 bis 40 Gew.-% aufweist.

6. Verfahren nach Anspruch 1, wobei der erste Schritt durch Auflösen des Elektrodenaktivmaterials in einer wässrigen Salpetersäurelösung mit einer Salpetersäurekonzentration von 20 bis 40 Gew.-% und dann Rühren des resultierenden Produkts bei Raumtemperatur für mindestens 20 Stunden durchgeführt wird.

7. Verfahren nach Anspruch 1, wobei der dritte Schritt durch Auflösen des auf die Elektrode plattierten Metallfremdmaterials unter Verwendung von Säure und dann Messen einer Menge des aufgelösten Metallfremdmaterials durch induktiv gekoppeltes Plasma (ICP) durchgeführt wird.

8. Verfahren nach Anspruch 7, wobei die Säure Salzsäure, Salpetersäure, Wasserstoffperoxid oder eine Mischung davon umfasst.

9. Verfahren nach Anspruch 7, wobei die Säure mindestens eines von Salzsäure und Salpetersäure und Wasserstoffperoxid umfasst.

10. Verfahren nach Anspruch 1, wobei der dritte Schritt durch anodische Stripping-Voltammetrie durchgeführt wird.

## Revendications

1. Procédé de détection d'un matériau métallique étranger dans un matériau actif d'électrode, le procédé comprenant :
une première étape de dissolution d'un matériau actif d'électrode dans une solution aqueuse d'acide nitrique pour former une solution d'extraction de matériau métallique étranger ;
une deuxième étape de placage d'un matériau métallique étranger dans la solution d'extraction de matériau métallique étranger sur une électrode de carbone, dans lequel la deuxième étape est effectuée en immergeant l'électrode de carbone dans la solution d'extraction de matériau métallique étranger et puis en appliquant un courant pour permettre une différence de potentiel dans laquelle un composant métallique du matériau actif d'électrode n'est pas réduit et le matériau métallique étranger à extraire est réduit ; et
une troisième étape de mesure d'une quantité de matériau métallique étranger plaqué sur l'électrode.

2. Procédé selon la revendication 1, dans lequel le matériau actif d'électrode comprend un matériau métallique étranger ayant une grosseur de particule de 40 µm ou moins.

3. Procédé selon la revendication 2, dans lequel le matériau métallique étranger en est au moins un sélectionné parmi le groupe composé de Cu, Zn, Ti, Sn, Pb et d'un alliage de ceux-ci.

4. Procédé selon la revendication 1, dans lequel la première étape est effectuée dans des conditions telles que le matériau métallique étranger a une solubilité de 80 % ou plus et un composant métallique du matériau actif d'électrode a une solubilité de 50 % ou moins.

5. Procédé selon la revendication 1, dans lequel la solution aqueuse d'acide nitrique a une concentration d'acide nitrique de 20 à 40 % en poids.

6. Procédé selon la revendication 1, dans lequel la première étape est effectuée en dissolvant le matériau actif d'électrode dans une solution aqueuse d'acide nitrique ayant une concentration d'acide nitrique de 20 à 40 % en poids, et puis en agitant le produit résultant à température ambiante pendant 20 heures au moins.

7. Procédé selon la revendication 1, dans lequel la troisième étape est effectuée en dissolvant le matériau métallique étranger plaqué sur l'électrode en utilisant de l'acide et puis en mesurant une quantité du matériau métallique étranger dissous par plasma à couplage inductif (ICP).

8. Procédé selon la revendication 7, dans lequel l'acide comprend de l'acide chlorhydrique, de l'acide nitrique, du peroxyde d'hydrogène ou un mélange de ceux-ci.

9. Procédé selon la revendication 7, dans lequel l'acide comprend au moins l'un d'entre de l'acide chlorhydrique et de l'acide nitrique et du peroxyde d'hydrogène.

10. Procédé selon la revendication 1, dans lequel la troisième étape est effectuée par voltampérométrie par décapage anodique.
